# EUROPÄISCHE PATENTSCHRIFT

(11) **EP 3 549 415 B1**
(45) Veröffentlichungstag und Bekanntmachung des Hinweises auf die Patenterteilung: **01.02.2023**
(21) Anmeldenummer: 17797128.0
(22) Anmeldetag: 07.11.2017
(51) Int. Cl.: H05K 5/06

(54) **DICHTUNG ZUR ABDICHTUNG VON BAUTEILHÄLFTEN**
SEAL FOR SEALING COMPONENT HALVES
JOINT D'ÉTANCHÉITÉ RENDANT ÉTANCHES DEUX MOITIÉS D'UNE PIÈCE

(30) Priorität: 02.12.2016 DE 102016123314
(43) Veröffentlichungstag der Anmeldung: 09.10.2019
(73) Patentinhaber: Phoenix Contact GmbH & Co KG, 32825 Blomberg (DE)
(72) Erfinder: BURY, Joachim, 92224 Amberg (DE); SALOMON, Thomas, 33415 Verl (DE)
(74) Vertreter: Patentship Patentanwaltsgesellschaft mbH
(86) Internationale Anmeldenummer: PCT/EP2017/078397
(87) Internationale Veröffentlichungsnummer: WO 2018/099695

(56) Entgegenhaltungen:
- WO-A1-2013/155091
- WO-A1-2015/074422
- DE-U1-202014 010 752
- GB-A- 2 026 448
- US-A- 5 422 766
- US-A1- 2009 307 983
- US-B2- 7 441 525

## Beschreibung

Die Erfindung betrifft eine Anordnung mit zwei Bauteilhälften und einer Dichtung zur Abdichtung der Bauteilhälften mit zwei symmetrisch zueinander ausgebildeten und in einer Symmetrieebene miteinander verbundenen Dichtungskörpern.

Eine konventionelle Dichtung zum Einsatz zwischen zwei Bauteilhälften bildet in der Regel eine Ebene oder eine Linienebene und entfaltet ihre Wirkung nur bei entsprechender axialer oder radialer Verpressung der Bauteilhälften zueinander. Zum Ausgleich von Toleranzen der Bauteilhälften sind nahe beieinanderliegende Verschraubungspunkte erforderlich. D.h. die Dichtung muss an einer Vielzahl von Verschraubungspunkten mit den Bauteilhälften verschraubt werden. Die Verwendung der Dichtung erfordert ferner Bauteilhälften mit geringen Fertigungstoleranzen zueinander. Außerdem ist die Dichtung aufgrund der Verpressung durch die Verschraubung an der Bauteilhälften und der damit verbundenen, bleibenden Dichtungskonturverprägung nicht dafür geeignet, wiederverwendbar montiert und demontiert zu werden.

Die Druckschrift DE 20 2014 010752 U1 betrifft ein Funktionskomponentengehäuse mit einer Dichtung. Die Dichtung 106 weist einen Grundkörper 118 aus einem ersten Material auf und ein Dichtungselement 120 aus einem zweiten Material, das elastischer als das erste Material ist.

Die Druckschrift US 7 441 525 B2 betrifft eine Zylinderkopfabdeckung für einen Zylinderkopf in einer Maschine mit einer Dichtung 6. Die Dichtung 6 hat einen Mittelsteg 16, von dem aus sich zwei pinienförmige Dichtelemente 14 nach oben und nach unten erstrecken, welche in jeweilige Nuten von Zylinderkopf 1 und Zylinderkopfabdeckung 2 eingreifen.

Die Druckschrift GB 2 026 448 A betrifft demontierbare Dichtungsanordnungen. Eine Dichtung 16 mit zwei Dichtelementen kreisförmigen Querschnitts wird in entsprechende Nuten von zwei Bauteilen eingelegt, um Dichtwirkung zwischen den Bauteilen zu erzeugen.

Die Druckschrift US 5 422 766 A betrifft eine Dichtung 8 zum Abdichten einer Diskettenlaufwerkanordnung. Die Dichtung 8 hat einen X-förmigen Querschnitt, ist symmetrisch aufgebaut sowohl in vertikaler als auch in horizontaler Richtung und besteht aus einem Elastomer-Material.

Es ist die Aufgabe der vorliegenden Erfindung, eine Dichtung zu schaffen, die zum Einbau in zwei Bauteilhälften mit möglichst wenigen Verschraubungspunkten auskommt und zusätzlich größere Fertigungstoleranzen der Bauteilhälften zulässt. Außerdem soll das Dichtungssystem wiederverwendbar einfach montier- und demontierbar sein, gut gegen Verschmutzung geschützt sein und mit variablen Verfahren in unterschiedlichen Ausführungen und Werkstoffen herstellbar sein.

Diese Aufgabe wird durch die Gegenstände mit den Merkmalen nach den unabhängigen Ansprüchen gelöst. Vorteilhafte Ausführungsformen sind Gegenstand der abhängigen Ansprüche, der Beschreibung und der Zeichnungen.

Gemäß einem ersten Aspekt wird die Aufgabe gelöst durch eine Anordnung mit zwei Bauteilhälften sowie einer Dichtung gemäß Anspruch 1.

Eine solche Anordnung mit Bauteilhälften und Dichtung bietet den Vorteil einer schmutzunempfindlichen geschützten Dichtungsnut, die für Kunststoff- sowie Metallbauteile einfach herstellbar ist. Die Dichtung ist dabei toleranzunsensibel und toleranzausgleichend in axialer und radialer Richtung, die radiale Dichtwirkung ist nur abhängig vom Dichtungsprofil- und den Dichtungsnuttoleranzen, die sehr gut beherrschbar und kontrollierbar sind. Die Dichtung wirkt gehäusezentrierend und passt sich den jeweiligen Versätzen elastisch an. Damit lässt sich ein reversibles Dichtungskonzept realisieren, da die Dichtung flächig radial in einer Nut verpresst wird und nicht axial durch umlaufende Dichtstege an den Gehäusebauteilen kantenverprägt wird, wodurch sehr gute Wiederholdichtigkeit nach Demontage gewährleistet ist. Nach diesem Dichtungskonzept, das als vorwiegend radial bezeichnet werden kann, sind geringe axiale Füge- und Haltekräfte nötig. Beispielsweise sind bereits vier Eckverschraubungspunkte ausreichend. Die symmetrisch aufgebaute Dichtung ist verwechslungssicher zu montieren und auswechselbar.

In einer vorteilhaften Ausführungsform der Anordnung mit Bauteilhälften und Dichtung sind die beiden Dichtungskörper konisch ausgeformt.

Dadurch wird der technische Vorteil einer Selbstentlüftung beim Fügen der Bauteilhälften gewährleistet.

In einer vorteilhaften Ausführungsform der Anordnung mit Bauteilhälften und Dichtung sind die beiden Dichtungskörper ausgebildet, beim Eingreifen in die jeweiligen Nuten der beiden Bauteilhälften sich gehäusezentrierend und elastisch dem Fertigungsversatz der Nuten anzupassen.

Dadurch wird der technische Vorteil erreicht, dass die beiden Bauteilhälften mit größeren Fertigungstoleranzen gefertigt sein können, welche aufgrund der Zentrierwirkung der Dichtung beim Zusammenfügen ausgeglichen werden können.

In einer vorteilhaften Ausführungsform umfasst die Dichtung einen Steg, der entlang der Symmetrieebene angeordnet ist, und die beiden Dichtungskörper miteinander verbindet.

Dadurch wird der technische Vorteil erreicht, dass der Steg die beiden Dichtungshälften fest zusammenhält und damit zu einer erhöhten Stabilität der Dichtung, insbesondere beim Herausziehen aus den Nuten, beiträgt.

In einer vorteilhaften Ausführungsform der Anordnung mit Bauteilhälften und Dichtung ist die Dichtung sowohl axial als auch radial symmetrisch ausgeformt.

Dadurch wird der technische Vorteil erreicht, dass die Dichtung verwechslungssicher von beiden Richtungen aus einsetzbar ist.

In einer vorteilhaften Ausführungsform der Anordnung mit Bauteilhälften und Dichtung ist die Dichtung kreisförmig, oval, rechteckförmig, dreieckförmig, quadratisch, polygonförmig oder entsprechend einer beliebigen Linienkontur ausgebildet.

Dadurch wird der technische Vorteil erreicht, dass die Dichtung für verschiedenste Formen von Gehäusen und Linienkonturen der Dichtungsnut hergestellt werden kann.

Erfindungsgemäß ist die Dichtung entlang einer geschlossenen Linienkontur, vorgegeben durch den Nutverlauf, ausgebildet.

Dadurch wird der technische Vorteil erreicht, dass eine vollständige Dichtwirkung der beiden Bauteilhälften zueinander als auch gegenüber der inneren und äußeren Umgebung realisiert werden kann.

In einer vorteilhaften Ausführungsform der Anordnung mit Bauteilhälften und Dichtung umfasst die Dichtung eine Mehrzahl von Verschraubungsöffnungen zum Verschrauben und Halten der Dichtung in zumindest einer der beiden Bauteilhälften.

Dadurch wird der technische Vorteil erreicht, dass die Dichtung fest an die jeweiligen Bauteilhälften angebracht werden kann und nicht mehr herausfallen kann.

In einer vorteilhaften Ausführungsform der Anordnung mit Bauteilhälften und Dichtung umfassen die beiden Dichtungskörper jeweils zumindest eine radial um den jeweiligen Dichtungskörper umlaufende Wulst.

Dadurch wird der technische Vorteil erreicht, dass eine Vielzahl an Dichtzonen entsteht, so dass Fertigungstoleranzen der Nuten und Bauteilhälften ausgeglichen werden können und redundante Dichtungsflächen entstehen.

In einer vorteilhaften Ausführungsform der Anordnung mit Bauteilhälften und Dichtung umfassen die beiden Dichtungskörper jeweils zwei radial um den jeweiligen Dichtungskörper umlaufende Wülste, welche jeweils durch eine Einschnürung voneinander getrennt sind; und wobei jede Wulst eine Dichtwirkung entfaltet.

Dies erhöht die Dichtwirkung der Dichtung.

In einer vorteilhaften Ausführungsform der Anordnung mit Bauteilhälften und Dichtung umfassen die beiden Dichtungskörper jeweils ein Labyrinth von Dichtzonen.

Dadurch wird der technische Vorteil erreicht, dass über das Labyrinth der Dichtzonen eine verbesserte Dichtwirkung realisiert werden kann.

In einer vorteilhaften Ausführungsform der Anordnung mit Bauteilhälften und Dichtung weisen die beiden Dichtungskörper jeweils einen kreisförmigen Querschnitt auf, und können im eingepressten Zustand etwas deformiert sein.

Dadurch wird der technische Vorteil erreicht, dass die Dichtungskörper leicht herstellbar sind und sich leicht in die jeweilige Nut einlegen bzw. einpressen lassen.

In einer vorteilhaften Ausführungsform der Anordnung mit Bauteilhälften und Dichtung umfassen die beiden Dichtungskörper jeweils zwei kreisförmige Elemente, die in ihrer gemeinsamen Querschnittsform wie eine Acht ausgebildet sind.

Dadurch wird der technische Vorteil erreicht, dass mehrere Dichtzonen entstehen, die flexibel in Nut eingepresst werden können.

In einer vorteilhaften Ausführungsform der Anordnung mit Bauteilhälften und Dichtung weist das zuerst in die entsprechende konische Nut der Bauteilhälfte eingreifende kreisförmige Element einen kleineren Durchmesser auf als das danach in die konische Nut eingreifende kreisförmige Element.

Dadurch kann mit bis zu sieben (oder mehr) parallelen Dichtungsebenen pro Dichtungsnut (z.B. 4x radial, 3x axial) eine hohe Dichtungswirkung, eine hohe Redundanz und eine dauerhafte Dichtqualität realisiert werden.

Erfindungsgemäß ist die Dichtung als einstückiges Elastomerteil ausgebildet.

Dadurch wird der technische Vorteil erreicht, dass für die Elastomerdichtung in einer Ausführung als separates Bauteil Werkstoffe mit optimalen spezifischen Eigenschaften zur Verfügung stehen, wie z.B. geringer Druckverformungsrest, verschiedene Shore-Härten, erhöhte Chemikalienbeständigkeit etc. Eine einstückige Ausführung verleiht der Dichtung eine erhöhte Stabilität.

In einer Ausführungsform, die nicht Teil der beanspruchten Erfindung ist, ist die Dichtung als einstückiges Extrusionsteil ausgebildet, das an den stirnseitigen Stoßflächen vorzugsweise durch Vulkanisation, Verschweißung oder Verklebung verbunden ist.

Dadurch wird der technische Vorteil erreicht, dass die Dichtung einen geschlossenen Dichtungsprofilring bildet.

Erfindungsgemäß ist die Dichtung als einstückiges Extrusionselastomerformteil ausgebildet, das mit Längenübermaß in eine der Nuten eingelegt wird.

Dadurch wird der technische Vorteil erreicht, dass an den stirnseitigen Stoßflächen durch das Längenübermaß eine dichtende Verpressung erzeugt wird.

Weitere Ausführungsbeispiele werden Bezug nehmend auf die beiliegenden Zeichnungen erläutert. Es zeigen:
- Fig. 1: eine schematische Darstellung einer Anordnung 100 mit zwei Bauteilhälften 102, 103 und eingepresster Dichtung 101 gemäß einer ersten Ausführungsform,
- Fig. 2: eine schematische Darstellung einer Anordnung 200 mit zwei Bauteilhälften 102, 103 und eingepresster einer Dichtung 201 gemäß einer zweiten Ausführungsform,
- Fig. 3: eine dreidimensionale Darstellung einer rechteckförmigen Dichtung 300 gemäß einer dritten Ausführungsform,
- Fig. 4a: eine Draufsicht auf die rechteckförmige Dichtung 300 gemäß der dritten Ausführungsform,
- Fig. 4b: eine Seitenansicht der kürzeren Seite der rechteckförmigen Dichtung 300 gemäß der dritten Ausführungsform,
- Fig. 4c: eine Seitenansicht der längeren Seite der rechteckförmigen Dichtung 300 gemäß der dritten Ausführungsform,
- Fig. 4d: eine Schnittdarstellung der rechteckförmigen Dichtung 300 gemäß der dritten Ausführungsform, geschnitten an der längeren Seite,
- Fig. 5a: eine dreidimensionale Darstellung einer kreisförmigen Dichtung 400 gemäß einer vierten Ausführungsform,
- Fig. 5b: eine weitere dreidimensionale Darstellung der kreisförmigen Dichtung 400 gemäß der vierten Ausführungsform,
- Fig. 5c: eine Draufsicht auf die kreisförmige Dichtung 400 gemäß der vierten Ausführungsform,
- Fig. 5d: eine Seitenansicht der kreisförmigen Dichtung 400 gemäß der vierten Ausführungsform,
- Fig. 5e: eine Schnittdarstellung der kreisförmigen Dichtung 400 gemäß der vierten Ausführungsform,
- Fig. 6: eine Explosionsdarstellung einer oberen Bauteilhälfte 602, einer unteren Bauteilhälfte 603 und der zwischen den beiden Bauteilhälften 602, 603 gelegenen rechteckförmigen Dichtung 300 gemäß der dritten Ausführungsform,
- Fig. 7: eine Schnittdarstellung 700 der zwischen zwei Bauteilhälften 602, 603 eingepressten Dichtung 300 gemäß der dritten Ausführungsform,
- Fig. 8a: eine Schnittdarstellung 800a der mit beiden O-Ringen in eine Nut der oberen Bauteilhälfte 602 eingepressten Dichtung 300 gemäß der dritten Ausführungsform,
- Fig. 8b: eine Schnittdarstellung 800b der nur mit dem oberen O-Ring in die Nut der oberen Bauteilhälfte 602 eingepressten Dichtung 300 gemäß der dritten Ausführungsform, und
- Fig. 9: eine Schnittdarstellung 900 zweier mit der Dichtung 300 gemäß der dritten Ausführungsform verschraubter Bauteilhälften 602, 603.

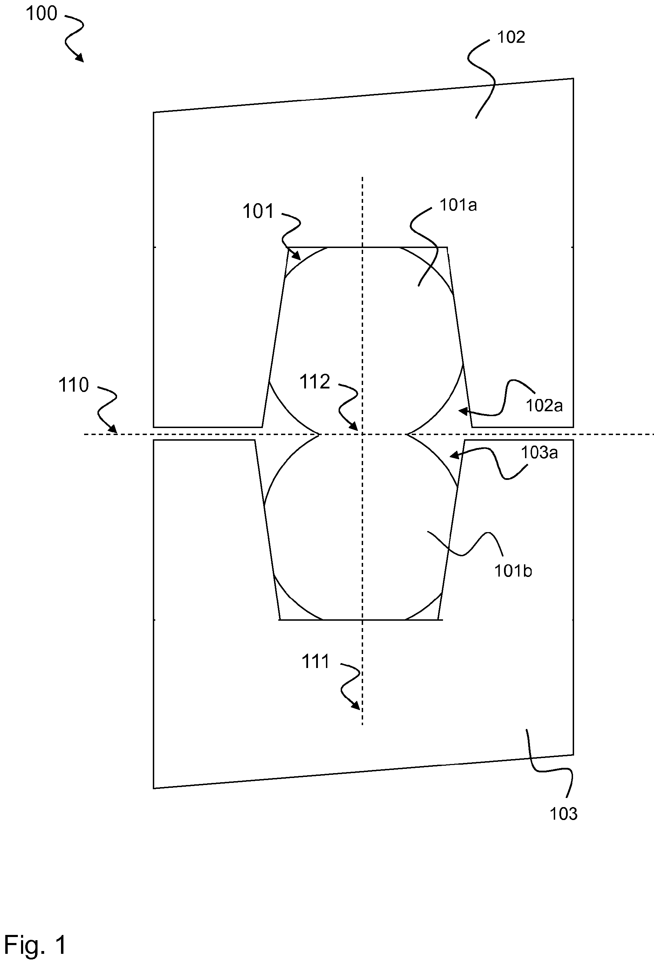

Die Fig. 1 zeigt eine schematische Darstellung einer Anordnung 100 mit zwei Bauteilhälften 102, 103 und eingepresster Dichtung 101 gemäß einer ersten Ausführungsform. Die Dichtung 101 dient dabei zur Abdichtung der zwei Bauteilhälften 102, 103. Die Dichtung 101 umfasst zwei symmetrisch zueinander ausgebildete und in einer Symmetrieebene 110 miteinander verbundene Dichtungskörper 101a, 101b. Der erste Dichtungskörper 101a greift radial und axial dichtend in eine Nut 102a der ersten Bauteilhälfte 102 ein. Der zweite Dichtungskörper 101b greift radial und axial dichtend in eine Nut 103a der zweiten Bauteilhälfte 103 ein. Mit der Dichtung 101 werden die zwei Bauteilhälften 102, 103 sowohl gegeneinander als auch zur Umgebung hin, d.h. nach innen und außen abgedichtet.

Die beiden Nuten 102a und 103a sind konisch ausgeformt, in etwa in Form eines U oder V. Die beiden Dichtungskörper 101a, 101b sind kreisförmig oder kugelförmig ausgeformt und eignen sich damit dazu, in die beiden Nuten 102a, 103a einzugreifen. Die Kreisform bzw. Kugelform der beiden Dichtungskörper 101a, 101b kann in dem Abschnitt, der zuerst in die jeweiligen Nuten 102a, 103a eingreift, ebenfalls als konisch angesehen werden, d.h. sich verjüngend korrespondierend zu der jeweiligen Nut 102a, 103a. Damit wird die Luft in der jeweiligen Nut 102a, 103a beim Eingreifen des jeweiligen Dichtungskörpers 101a, 101b optimal verdrängt und es bilden sich keine Luftblasen. Folglich verbessert sich die Dichtwirkung.

Beim Eingreifen in die jeweiligen Nuten 102a, 103a der beiden Bauteilhälften 102, 103 passen sich die beiden Dichtungskörper 101a, 101b elastisch den Nuten 102a, 103a an, so dass auch höhere Fertigungstoleranzen bei der Fertigung der Bauteilhälften und der Nuten ausgeglichen werden können.

Die Dichtung 101 ist sowohl axial als auch radial symmetrisch ausgeformt. Die axiale Symmetrie ist durch die (horizontale) Symmetrieebene 110 gegeben. Die radiale Symmetrie ist durch die Verbindungslinie 111 der beiden Mittelpunkte des (kreisförmigen bzw. kugelförmigen) oberen Dichtungskörpers 101a und des unteren (kreisförmigen bzw. kugelförmigen) Dichtungskörpers 101b gegeben. Es besteht sogar Punktsymmetrie bezüglich des Schnittpunktes 112 der besagten Verbindungslinie 111 mit der Symmetrieebene 110.

Die Dichtung 100 kann kreisförmig, oval, rechteckförmig, dreieckförmig, quadratisch, polygonförmig oder entsprechend einer beliebigen Linienkontur ausgebildet sein, was aus Figur 1 jedoch nicht hervorgeht, da es sich um eine Schnittdarstellung handelt. Die Dichtung kann dazu entlang einer geschlossenen Linienkontur, vorgegeben durch die Form der Bauteilhälften 102, 103 oder einem beliebigen Dichtungsnutverlauf ausgebildet sein, was auch aus Figur 1 nicht ersichtlich ist.

Die beiden Dichtungskörper 101a, 101b haben jeweils einen kreisförmigen Querschnitt, der im eingepressten Zustand allerdings etwas deformiert ist, wie aus Figur 1 ersichtlich ist. Alternativ können die beiden Dichtungskörper 101a, 101b in Form einer Acht ausgebildet sein und dabei jeweils zwei kreisförmige Elemente umfassen, die beispielsweise unterschiedliche Radien aufweisen können. Die Dichtung 101 ist als ein einstückiges Elastomerteil ausgebildet, z.B. Gummi, Kautschuk oder Kunststoff, wie beispielsweise einem thermoplastischen Kunststoff, kann jedoch auch aus anderen Materialien gefertigt sein, z.B. einem Verbundwerkstoff oder anderen.

Die beiden Bauteilhälften 102, 103 können Kunststoff- oder Metallbauteile oder aus einem anderen beliebigen Werkstoff sein.

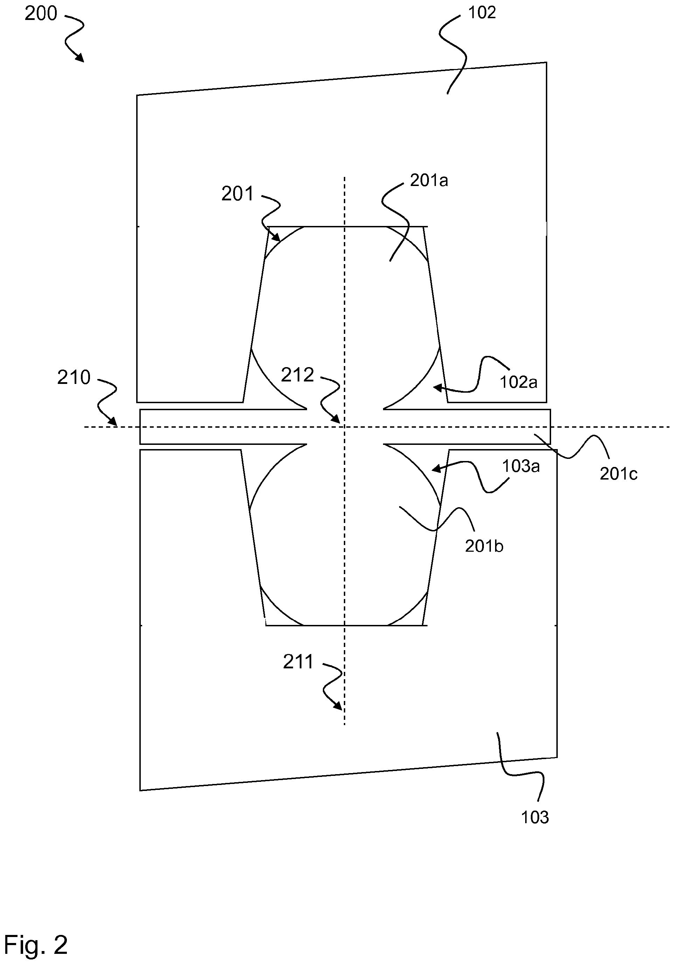

Die Fig. 2 zeigt eine schematische Darstellung einer Anordnung 200 mit zwei Bauteilhälften 102, 103 und eingepresster einer Dichtung 201 gemäß einer zweiten Ausführungsform. Die Dichtung 201 dient dabei zur Abdichtung der zwei Bauteilhälften 102, 103. Die Dichtung 201 umfasst zwei symmetrisch zueinander ausgebildete und über einen Steg 201c in einer Symmetrieebene 210 miteinander verbundene Dichtungskörper 201a, 201b. Der erste Dichtungskörper 201a greift radial und axial dichtend in eine Nut 102a der ersten Bauteilhälfte 102 ein. Der zweite Dichtungskörper 201b greift radial und axial dichtend in eine Nut 103a der zweiten Bauteilhälfte 103 ein. Mit der Dichtung 201 werden die zwei Bauteilhälften 102, 103 sowohl gegeneinander als auch zur Umgebung hin, d.h. nach innen und außen abgedichtet.

Die Form der beiden Dichtungskörper 201a, 201b entspricht der Form der oben zu Figur 1 bereits beschriebenen Dichtungskörper 101a, 101b und bietet die gleichen Vorteile.

Beim Eingreifen in die jeweiligen Nuten 102a, 103a der beiden Bauteilhälften 102, 103 passen sich die beiden Dichtungskörper 201a, 201b elastisch den Nuten 102a, 103a an, so dass auch höhere Fertigungstoleranzen bei der Fertigung der Bauteilhälften und der Nuten ausgeglichen werden können. Der Steg 201c erlaubt zusätzlich den Ausgleich von Toleranzen, die dadurch entstehen, dass die Oberflächen der beiden Bauteilhälften 102, 103 nicht optimal planar ausgeformt sind.

Die Dichtung 201 ist sowohl axial als auch radial symmetrisch ausgeformt. Die axiale Symmetrie ist durch die (horizontale) Symmetrieebene 210 gegeben. Die radiale Symmetrie ist durch die Verbindungslinie 211 der beiden Mittelpunkte des (kreisförmigen bzw. kugelförmigen) oberen Dichtungskörpers 201a und des unteren (kreisförmigen bzw. kugelförmigen) Dichtungskörpers 201b gegeben. Es besteht sogar Punktsymmetrie bezüglich des Schnittpunktes 212 der besagten Verbindungslinie 211 mit der Symmetrieebene 210.

Die Dichtung 200 kann kreisförmig, oval, rechteckförmig, dreieckförmig, quadratisch, polygonförmig oder entsprechend einer beliebigen Linienkontur ausgebildet sein, was aus Figur 2 jedoch nicht hervorgeht, da es sich um eine Schnittdarstellung handelt. Die Dichtung ist entlang einer geschlossenen Linienkontur, vorgegeben durch den Nutverlauf, ausgebildet, was auch aus Figur 2 nicht ersichtlich ist.

Die beiden Dichtungskörper 201a, 201b haben jeweils einen kreisförmigen Querschnitt, der im eingepressten Zustand allerdings etwas deformiert ist, wie aus Figur 2 ersichtlich ist. Alternativ können die beiden Dichtungskörper 201a, 201b in Form einer Acht ausgebildet sein und dabei jeweils zwei kreisförmige Elemente umfassen, die beispielsweise unterschiedliche Radien aufweisen können. Die Dichtung 201 ist als ein einstückiges Elastomerteil ausgebildet, z.B. Gummi, Kautschuk oder Kunststoff, wie beispielsweise einem thermoplastischen Kunststoff, kann jedoch auch aus anderen Materialien gefertigt sein, z.B. einem Verbundwerkstoff oder anderen.

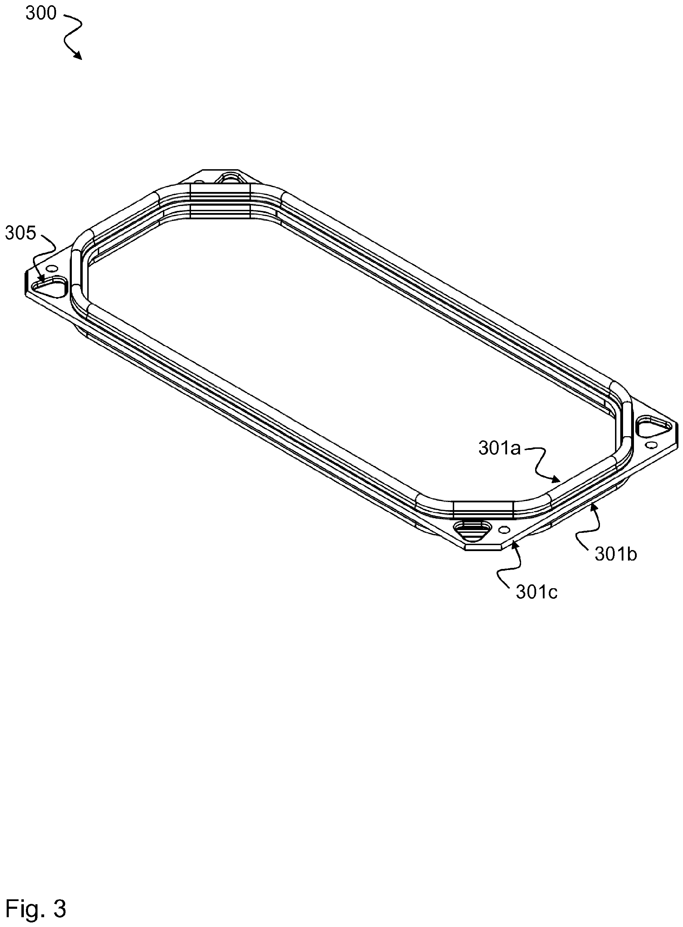

Die Fig. 3 zeigt eine dreidimensionale Darstellung einer rechteckförmigen Dichtung 300 gemäß einer dritten Ausführungsform. Die Dichtung 300 umfasst zwei symmetrisch zueinander ausgebildete und durch einen Steg 301c in einer Symmetrieebene miteinander verbundene Dichtungskörper 301a, 301b. Der erste Dichtungskörper 301a ist dafür vorgesehen, radial und axial dichtend in eine Nut einer ersten Bauteilhälfte (in Fig. 3 nicht dargestellt) einzugreifen. Der zweite Dichtungskörper 301b ist dafür vorgesehen, radial und axial dichtend in eine Nut einer zweiten Bauteilhälfte (in Fig. 3 nicht dargestellt) einzugreifen. Mit der Dichtung 300 können die zwei Bauteilhälften sowohl gegeneinander als auch zur Umgebung hin, d.h. nach innen und außen abgedichtet werden.

Die beiden Dichtungskörper 301a und 301b sind in Form einer Acht ausgebildet und umfassen dabei jeweils zwei kreisförmige Elemente, die unterschiedliche Radien aufweisen. Dabei weist das zuerst in die entsprechende Nut der Bauteilhälfte eingreifende kreisförmige Element des jeweiligen Dichtungskörpers 301a, 301b einen kleineren Durchmesser auf als das danach in die Nut eingreifende kreisförmige Element, so dass bereits beim Eingreifen des zuerst in die Nut eingreifenden kreisförmigen Elements eine Dichtwirkung erzielt wird.

Die Dichtung 300 weist vier Verschraubungsöffnungen 305 im Steg 301c zum Verschrauben der Dichtung 300 mit der oberen und/oder unteren Bauteilhälfte auf. Eine alternative Anzahl von Verschraubungsöffnungen 305 ist selbstverständlich auch möglich, beispielsweise 2, 3, 5, 6, 7, 8, etc.

Aufgrund des Aufbaus der Dichtungskörper 301a, 301b in Form einer Acht umfassen die beiden Dichtungskörper 301a, 301b jeweils zwei radial um den jeweiligen Dichtungskörper 701a, 701b umlaufende Wulste, welche durch die seitlichen Ausbuchtungen der Form der Acht gebildet werden. Die beiden Dichtungskörper bilden damit jeweils ein Labyrinth von Dichtzonen aus, an denen sie in die entsprechenden Nuten der Bauteilhälften eingreifen und für eine luft-, flüssigkeits- und gasfeste Dichtwirkung sorgen.

Durch die sich verjüngende Form der beiden Dichtungskörper 301a, 301b wird die Luft in der jeweiligen Nut beim Eingreifen des jeweiligen Dichtungskörpers 301a, 301b optimal verdrängt und es bilden sich keine Luftblasen. Folglich verbessert sich die Dichtwirkung. Beim Eingreifen in die jeweiligen Nuten der beiden Bauteilhälften passen sich die beiden Dichtungskörper 301a, 301b elastisch den Nuten an, so dass auch höhere Fertigungstoleranzen bei der Fertigung der Bauteilhälften und der Nuten ausgeglichen werden können.

In der Ausführungsform der Fig. 3 ist die Dichtung 300 rechteckig (mit abgerundeten Ecken) ausgeführt, sie kann jedoch auch kreisförmig, oval, dreieckförmig, quadratisch, polygonförmig oder entsprechend einer beliebigen Linienkontur ausgebildet sein. Die Dichtung 300 ist entlang einer geschlossenen Linienkontur, vorgegeben durch die Form der Bauteilhälften ausgebildet.

Die Dichtung 300 ist als ein einstückiges Elastomerteil ausgebildet, z.B. Gummi, Kautschuk .

Die beiden Bauteilhälften können Kunststoff- oder Metallbauteile oder aus einem anderen beliebigen Werkstoff sein.

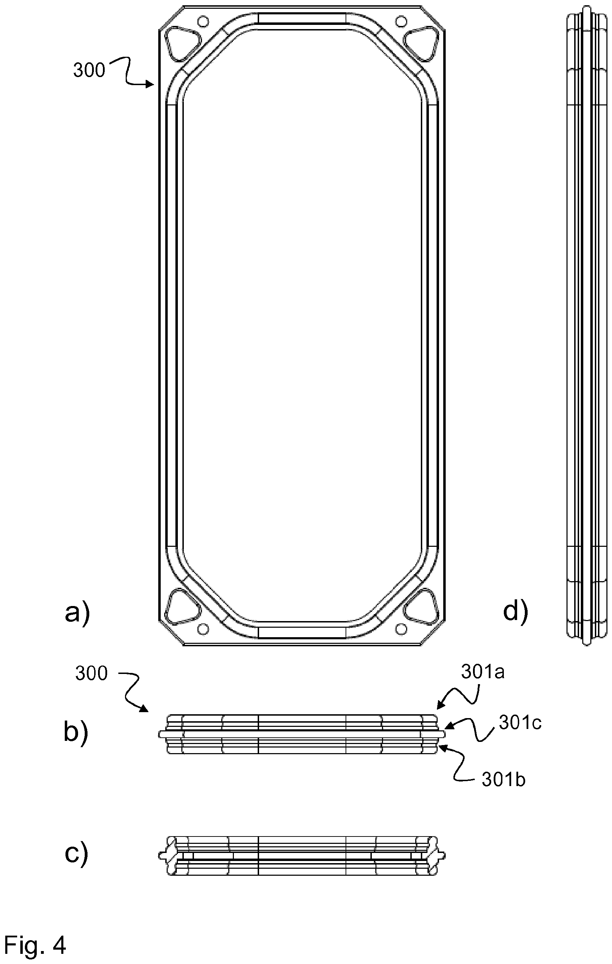

Die Fig. 4a zeigt eine Draufsicht auf die rechteckförmige Dichtung 300 gemäß der dritten Ausführungsform. Die Fig. 4b zeigt eine Seitenansicht der kürzeren Seite der rechteckförmigen Dichtung 300 gemäß der dritten Ausführungsform. Die Fig. 4c zeigt eine Seitenansicht der längeren Seite der rechteckförmigen Dichtung 300 gemäß der dritten Ausführungsform. Die Fig. 4d zeigt eine Schnittdarstellung der rechteckförmigen Dichtung 300 gemäß der dritten Ausführungsform, geschnitten an der längeren Seite.

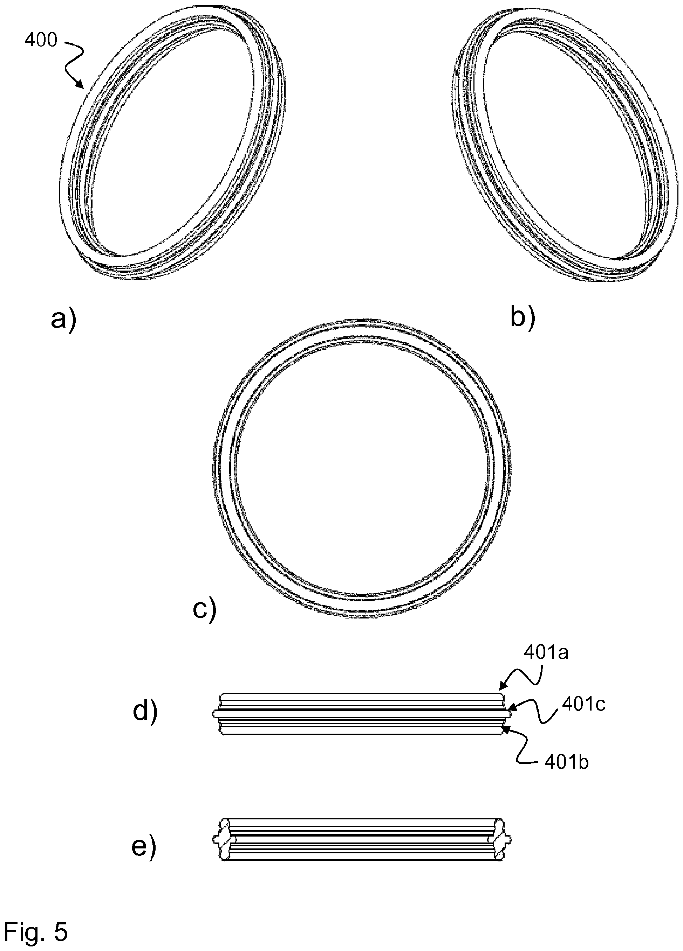

Die Fig. 5a zeigt eine dreidimensionale Darstellung einer kreisförmigen Dichtung 400 gemäß einer vierten Ausführungsform. Die kreisförmige Dichtung 400 unterscheidet sich von der rechteckförmigen Dichtung 300 gemäß Figur 3 nur dadurch, dass sie (entlang der Symmetrieebene) kreisförmig ist. Sie umfasst zwei symmetrisch zueinander ausgebildete und durch einen Steg 401c in einer Symmetrieebene miteinander verbundene Dichtungskörper 401a, 401b. Der erste Dichtungskörper 401a ist dafür vorgesehen, radial und axial dichtend in eine kreisförmige Nut einer ersten Bauteilhälfte (in Fig. 4 nicht dargestellt) einzugreifen. Der zweite Dichtungskörper 401b ist dafür vorgesehen, radial und axial dichtend in eine kreisförmige Nut einer zweiten Bauteilhälfte (in Fig. 4 nicht dargestellt) einzugreifen. Mit der Dichtung 400 können die zwei Bauteilhälften sowohl gegeneinander als auch zur Umgebung hin, d.h. nach innen und außen abgedichtet werden.

Die Fig. 5b zeigt eine weitere dreidimensionale Darstellung der kreisförmigen Dichtung 400 gemäß der vierten Ausführungsform. Die Fig. 5c zeigt eine Draufsicht auf die kreisförmige Dichtung 400 gemäß der vierten Ausführungsform. Die Fig. 5d zeigt eine Seitenansicht der kreisförmigen Dichtung 400 gemäß der vierten Ausführungsform. Die Fig. 5e zeigt eine Schnittdarstellung der kreisförmigen Dichtung 400 gemäß der vierten Ausführungsform.

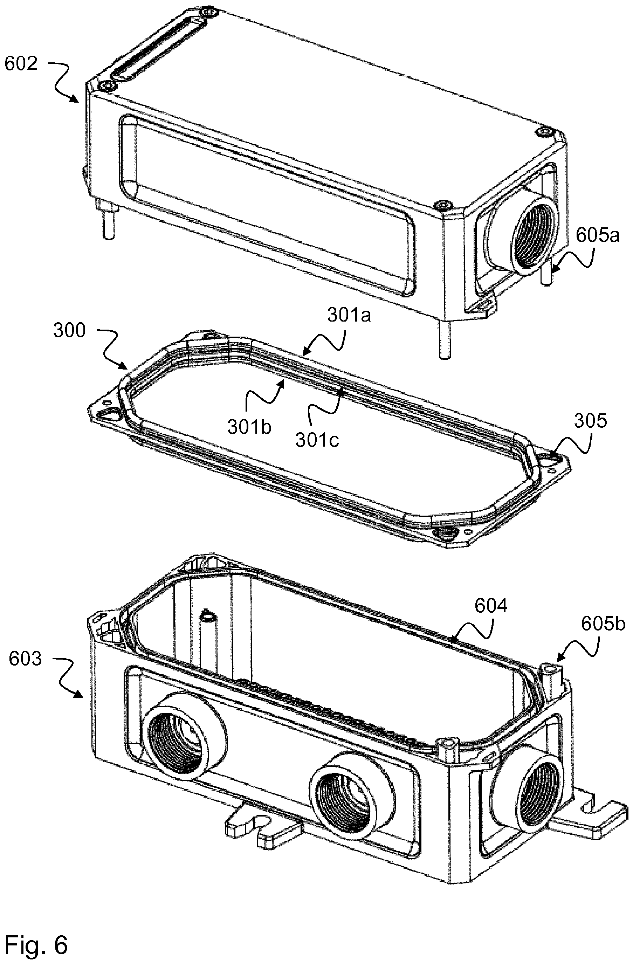

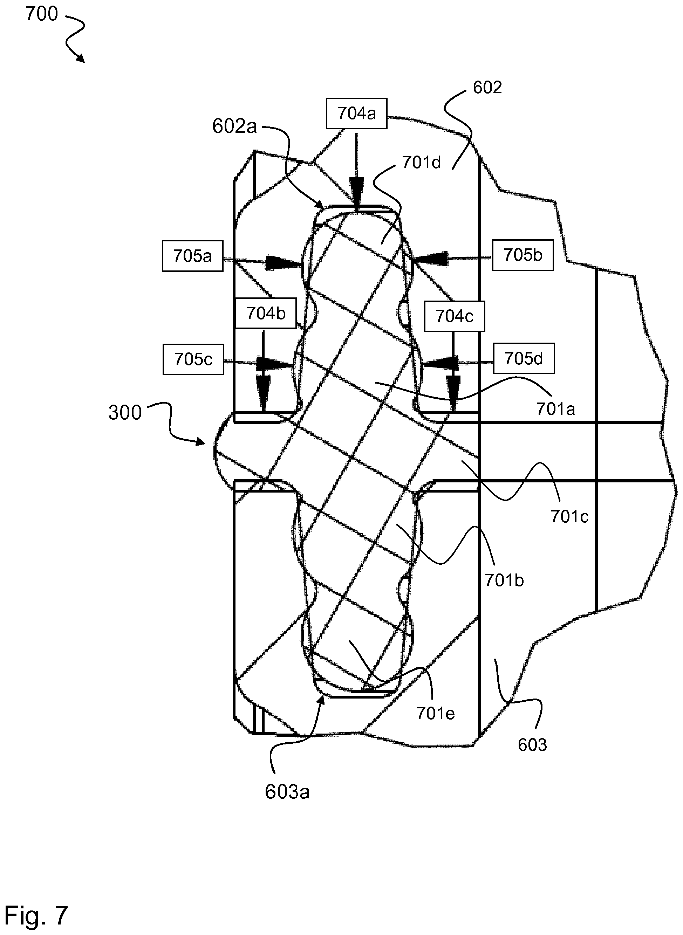

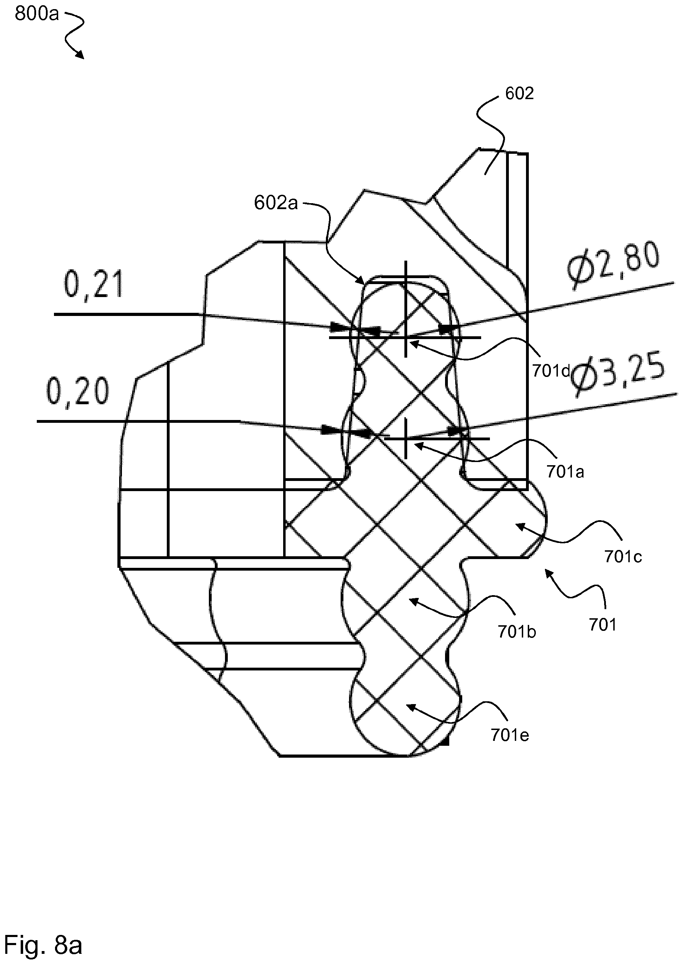

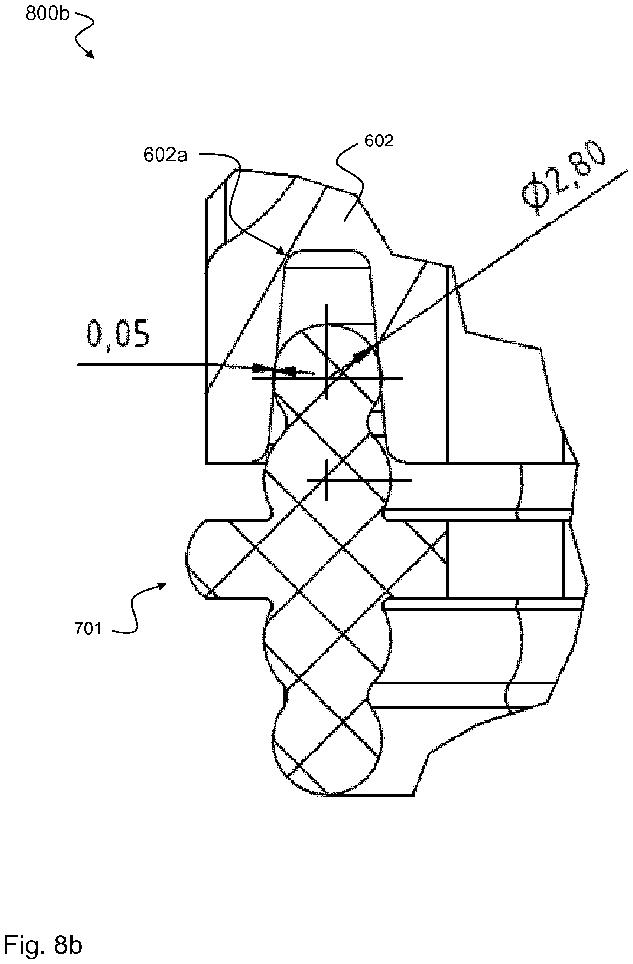

Die Fig. 6 zeigt eine Explosionsdarstellung einer oberen Bauteilhälfte 602, einer unteren Bauteilhälfte 603 und der zwischen den beiden Bauteilhälften 602, 603 gelegenen rechteckförmigen Dichtung 300 gemäß der dritten Ausführungsform. Beide Bauteilhälften 602, 603 weisen umlaufende Nuten 604 auf, in welche die Dichtung 300 eingepresst bzw. eingelegt werden kann. In der Fig. 6 ist nur die Nut 604 der unteren Bauteilhälfte 603 dargestellt, eine gleichartige Nut befindet sich auch in der oberen Bauteilhälfte 602. Die Dichtung kann mittels vier Schraubverbindungen 605a, 605b, welche durch entsprechende Öffnungen 305 in der Dichtung verlaufen zwischen oberer 602 und unterer 603 Bauteilhälfte befestigt werden und so für eine feste Dichtwirkung zwischen beiden Bauteilen 602, 603 sorgen. Die beiden Bauteilhälften 602, 603 enthalten symmetrisch eine identische Nut. In diese presst sich die Dichtung 300 ein, die damit zusätzlich zum axialen Dichtbereich ein Labyrinth mit fünf weiteren Dichtzonen bildet, wie unten zu den Figuren 7, 8a und 8b näher beschrieben. Der Dichtungsring ist einfach entnehmbar und wegen seiner Symmetrie beliebig, d.h. verwechslungssicher wieder einzulegen.

Die Dichtung 300 hat ihre Wirkung bereits mit der minimalen Anzahl von Verschraubungspunkten (beispielsweise vier, in den Ecken) und lässt zusätzlich größere Toleranzen der Bauteilhälften zu. Die Dichtung ist dabei einfach auswechselbar, indem die Verschraubungen 605a, 605b einfach gelöst und die Bauteilhälften 602, 603 voneinander getrennt werden. Die Dichtung 300 ist dreidimensional ausgeführt und taucht zentrierend, stabilisierend, sowie radial und axial dichtend in die Nuten 604 der beiden Bauteilhälften 602, 603 ein. Mit der Dichtung 300 können sowohl ein größeres Gehäuse, als auch dieses Gehäuse mit mehr Toleranzen realisiert werden. Ebenso verbessert sich die Wiederholdichtigkeit bei Demontage deutlich.

Ein Abdichten der beiden Bauteilhälften 602, 603 mit der Dichtung 300 bietet die folgenden Vorteile:
- schmutzunempfindliche geschützte Dichtungsnut 604, in Gehäuseunterteil und - oberteil symmetrisch ausgeführt;
- Dichtungsnut 604 für Kunststoff- sowie auch für Metallbauteile oder Gehäuse aus beliebigen Werkstoffen herstellbar;
- toleranzunsensibel und toleranzausgleichend in axialer und radialer Richtung, die radiale Dichtwirkung ist nur abhängig vom Dichtungsprofil- und den Dichtungsnuttoleranzen, die sehr gut beherrschbar und kontrollierbar sind;
- Dichtung 300 wirkt gehäusezentrierend und passt sich den jeweiligen Versätzen elastisch an;
- durch die Elastomerdichtung in einer Ausführung als separates Bauteil stehen Werkstoffe mit optimalen spezifischen Eigenschaften zur Verfügung (z.B. geringer Druckverformungsrest, verschiedene Shore-Härte, erhöhte Chemikalienbeständigkeit etc.);
- reversibles Dichtungskonzept da die Dichtung 300 flächig radial in einer Nut 604 verpresst wird und nicht axial durch umlaufende Dichtstege an den Gehäusebauteilen 602, 603 kantenverprägt wird, dadurch sehr gute Wiederholdichtigkeit nach Demontage;
- vorwiegend radiales Dichtungskonzept, dadurch sind geringe axiale Füge- und Haltekräfte nötig (4 Eckverschraubungspunkte sind ausreichend);
- durch Nutkonizität Selbstentlüftung beim Fügen der Bauteilhälften 602, 603;
- bis zu sieben (oder mehr) parallele Dichtungsebenen pro Dichtungsnut (z.B. 4x radial, 3x axial), hohe Dichtungswirkung und dauerhafte Dichtqualität;
- symmetrisch aufgebaute Dichtung 300, verwechslungssicher zu montieren und auswechselbar.

Die Fig. 7 zeigt eine Schnittdarstellung 700 der zwischen zwei Bauteilhälften 602, 603 eingepressten Dichtung 300 gemäß der dritten Ausführungsform.

Beide Bauteilhälften 602, 603 weisen umlaufende Nuten 602a, 603a auf, in welche die Dichtung 300 eingepresst bzw. eingelegt werden kann. Die Nut 603a entspricht dabei der Nut 604 der unteren Gehäuseöffnung 603 gemäß Figur 6. Die beiden Bauteilhälften 602, 603 enthalten symmetrisch eine identische Nut. In diese presst sich die Dichtung 300 ein, die damit zusätzlich zum axialen Dichtbereich ein Labyrinth mit fünf weiteren Dichtzonen bildet. D.h., die beiden Dichtungskörper 701a, 701b, 701d, 701e umfassen jeweils ein Labyrinth von Dichtzonen 704a, 704b, 704c, 705a, 705b, 705c, 705d. Dabei wirken die Dichtzonen 705a, 705b, 705c, 705d radial dichtend und die Dichtzonen 704a, 704b, 704c axial dichtend. Die Dichtung 300 ist einfach entnehmbar und wegen seiner Symmetrie beliebig, d.h. verwechslungssicher wieder einzulegen.

Die Fig. 8a zeigt eine Schnittdarstellung 800a der mit beiden O-Ringen in eine Nut der oberen Bauteilhälfte 602 eingepressten Dichtung 300 gemäß der dritten Ausführungsform. Die O-Ringe 701a, 701b, 701d, 701e entsprechen dabei den zuvor besagten kreisförmigen Elementen, aus denen die Acht des jeweiligen Dichtungskörpers ausgebildet ist. In Figur 8a ist die Dichtung mit beiden O-Ringen 701d, 701a, d.h. mit dem gesamten oberen Dichtungskörper in die Nut 602a der oberen Bauteilhälfte 602 eingepresst, was zu einer optimalen Dichtwirkung beiträgt.

Die Fig. 8b zeigt eine Schnittdarstellung 800b der nur mit dem oberen O-Ring in die Nut 602a der oberen Bauteilhälfte 602 eingepressten Dichtung 300 gemäß der dritten Ausführungsform. Eine Dichtwirkung kann bereits erzielt werden, wenn die Dichtung nur mit dem oberen O-Ring 701d, d.h. mit einem Teil des oberen Dichtungskörper in die Nut 602a der oberen Bauteilhälfte 602 eingepresst wird. Dieser Teil entspricht dem kreisförmigen Element des oberen Dichtungskörpers, das zuerst in die Nut 602a der oberen Bauteilhälfte 602 eingeführt wird.

In Fig. 8b sind beispielhafte Masse für den Durchmesser der O-Ringe 701d und 701a und die Dicke der Einpresszonen 705a, 705c angegeben. Beispielsweise kann der obere O-Ring 701d des oberen Dichtungskörpers einen Durchmesser von 2,8 Millimeter (mm) und der untere O-Ring 701a des oberen Dichtungskörpers einen Durchmesser von 3,25 mm aufweisen. Die obere Einpresszone 705a des oberen Dichtungskörpers kann abhängig von der Einpresstiefe des oberen Dichtungskörpers in die Nut eine Dicke von beispielsweise 0,21 mm bis 0,05 mm aufweisen. Die untere Einpresszone 705c des oberen Dichtungskörpers kann abhängig von der Einpresstiefe des oberen Dichtungskörpers in die Nut eine Dicke von beispielsweise 0,20 mm bis 0,13 mm aufweisen bzw. kann entsprechend der Darstellung der Fig. 8b gar nicht in die Nut eingeführt werden.

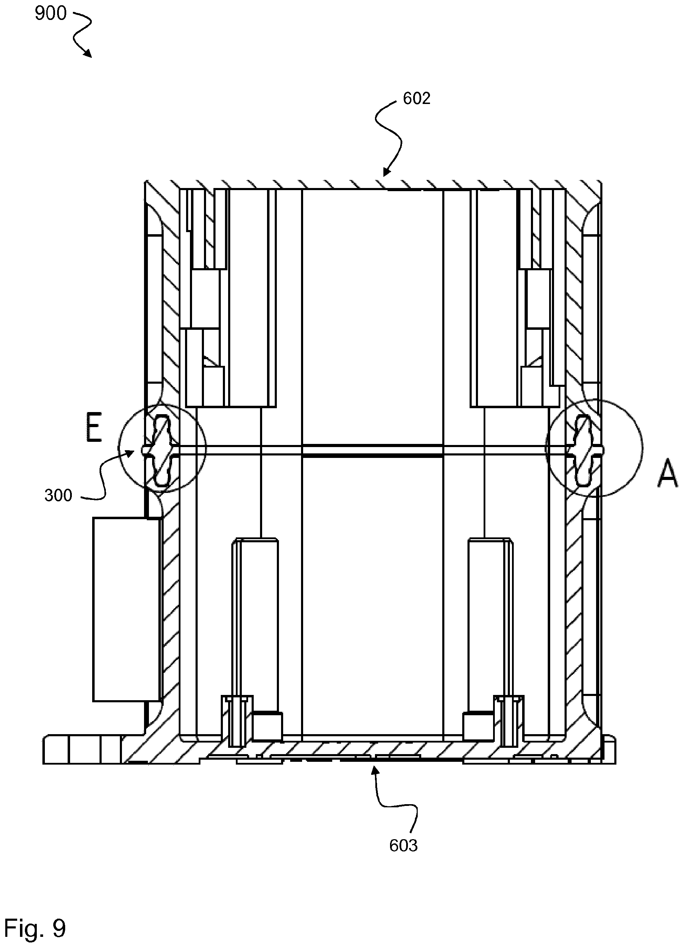

Die Fig. 9 zeigt eine Schnittdarstellung 900 zweier mit der Dichtung 300 gemäß der dritten Ausführungsform verschraubter Bauteilhälften 602, 603. Die Dichtung 300 bildet mit den beiden Bauteilhälften 602, 603 einen Kraft- und Formschluss und sorgt für die Abdichtung der beiden Bauteilhälften 602, 603 nach außen, nach innen und gegeneinander. Die Dichtwirkung kann gegen das Ein- bzw. Austreten von Gasen, Flüssigkeiten und Stäuben schützen.

### BEZUGSZEICHENLISTE

- 100: Anordnung mit zwei Bauteilhälften und eingepresster Dichtung gemäß einer ersten Ausführungsform
- 101: Dichtung gemäß der ersten Ausführungsform
- 101a: erster (oberer) Dichtungskörper
- 101b: zweiter (unterer) Dichtungskörper
- 102: erste (obere) Bauteilhälfte
- 103: zweite (untere) Bauteilhälfte
- 102a: Nut in oberer Bauteilhälfte
- 103a: Nut in unterer Bauteilhälfte
- 110: Symmetrieebene

- 200: Anordnung mit zwei Bauteilhälften und eingepresster Dichtung gemäß einer zweiten Ausführungsform
- 201: Dichtung gemäß der zweiten Ausführungsform
- 201a: erster (oberer) Dichtungskörper
- 201b: zweiter (unterer) Dichtungskörper
- 201c: Steg zwischen beiden Dichtungskörpern
- 210: Symmetrieebene

- 300: Dichtung gemäß einer dritten Ausführungsform
- 301a: erster (oberer) Dichtungskörper
- 301b: zweiter (unterer) Dichtungskörper
- 301c: Steg zwischen beiden Dichtungskörpern
- 305: Verschraubungsöffnung(en)

- 400: Dichtung gemäß einer vierten Ausführungsform
- 401a: erster (oberer) Dichtungskörper
- 401b: zweiter (unterer) Dichtungskörper
- 401c: Steg zwischen beiden Dichtungskörpern

- 602: erste (obere) Bauteilhälfte
- 603: zweite (untere) Bauteilhälfte
- 604: Nut in unterer Bauteilhälfte
- 602a: Nut in oberer Bauteilhälfte
- 603a: Nut in unterer Bauteilhälfte, entspricht 604
- 605a: Schrauben zum Verschrauben der oberen mit der unteren Bauteilhälfte
- 605b: Bolzen mit Gewinde zum Verschrauben der oberen mit der unteren Bauteilhälfte

- 700: Anordnung mit zwei Bauteilhälften und eingepresster Dichtung gemäß der dritten Ausführungsform
- 701d: erstes (äußeres) kreisförmiges Element des ersten (oberen) Dichtungskörpers
- 701a: zweites (inneres) kreisförmiges Element des ersten (oberen) Dichtungskörpers
- 701e: erstes (äußeres) kreisförmiges Element des zweiten (unteren) Dichtungskörpers
- 701b: zweites (inneres) kreisförmiges Element des zweiten (unteren) Dichtungskörpers
- 701c: Steg zwischen beiden Dichtungskörpern
- 704a: erster axialer Dichtbereich
- 704b: zweiter axialer Dichtbereich
- 704c: dritter axialer Dichtbereich
- 705a: erster radialer Dichtbereich
- 705b: zweiter radialer Dichtbereich
- 705c: dritter radialer Dichtbereich
- 705d: vierter radialer Dichtbereich

- 800a: Anordnung mit einer oberen Bauteilhälfte mit Nut und darin vollständig eingepresster Dichtung gemäß der fünften Ausführungsform
- 800b: Anordnung mit einer oberen Bauteilhälfte mit Nut und darin teilweise eingepresster Dichtung gemäß der fünften Ausführungsform

- 900: Anordnung mit zwei Bauteilhälften und eingepresster Dichtung gemäß der dritten Ausführungsform

## Patentansprüche

1. Anordnung mit zwei Bauteilhälften (102, 103) sowie einer Dichtung (101) zur Abdichtung der Bauteilhälften (102, 103), mit folgenden Merkmalen:
zwei symmetrisch zueinander ausgebildete und in einer Symmetrieebene (110) miteinander verbundene Dichtungskörper (101a, 101b),
wobei der erste Dichtungskörper (101a) mindestens radial oder auch zusätzlich axial dichtend in eine Nut (102a, 604a) der ersten Bauteilhälfte (102) eingreift; und
wobei der zweite Dichtungskörper (101b) mindestens radial oder auch zusätzlich axial dichtend in eine Nut (103a) der zweiten Bauteilhälfte (103) eingreift, um die zwei Bauteilhälften (102, 103) gegeneinander abzudichten,
wobei die Dichtung entlang einer geschlossenen Linienkontur, vorgegeben durch den Nutverlauf ausgebildet ist,
wobei die Dichtung (701) als einstückiges Extrusionselastomerformteil ausgebildet ist, das mit Längenübermaß in eine der Nuten (102a, 103a) eingelegt wird, wodurch ein geschlossener Dichtungsprofilring gebildet ist, bei dem an den stirnseitigen Stoßflächen durch das Längenübermaß eine dichtende Verpressung erzeugt wird.

2. Anordnung nach Anspruch 1,
wobei die beiden Dichtungskörper (101a, 101b) konisch ausgeformt sind.

3. Anordnung nach Anspruch 1 oder 2,
wobei die beiden Dichtungskörper (101a, 101b) ausgebildet sind, sich beim Eingreifen in die jeweiligen Nuten (102a, 103a) der beiden Bauteilhälften (102, 103) elastisch zentrierend den Nuten (102a, 103a) jeweils anzupassen.

4. Anordnung nach einem der vorstehenden Ansprüche, mit
einem Steg (201c), der entlang der Symmetrieebene (210) angeordnet ist, und die beiden Dichtungskörper (201a, 201b) miteinander verbindet und eine zusätzliche axiale Dichtungsebene bildet.

5. Anordnung nach Anspruch 4,
wobei die Dichtung (201) sowohl axial als auch radial symmetrisch ausgeformt ist.

6. Anordnung nach einem der vorstehenden Ansprüche,
wobei die Dichtung (101, 201) kreisförmig, oval, rechteckförmig, dreieckförmig, quadratisch, polygonförmig oder in einer beliebigen Linienkontur ausgebildet ist.

7. Anordnung nach einem der vorstehenden Ansprüche,
wobei die Dichtung (300) eine Mehrzahl von Verschraubungsöffnungen (305) zum Verschrauben der Dichtung (300) mit zumindest einer der beiden Bauteilhälften (602, 603), umfasst.

8. Anordnung nach einem der vorstehenden Ansprüche,
wobei die beiden Dichtungskörper (701a, 701b) jeweils zumindest eine radial um den jeweiligen Dichtungskörper (701a, 701b) umlaufende Wulst (705c, 705d) umfassen.

9. Anordnung nach Anspruch 8,
wobei die beiden Dichtungskörper (701a, 701b) jeweils zwei radial um den jeweiligen Dichtungskörper (701a, 701b) umlaufende Wülste (705c, 705d) umfassen, welche jeweils durch eine Einschnürung voneinander getrennt sind; und wobei jede Wulst eine eigene Dichtwirkung entfaltet.

10. Anordnung nach einem der vorstehenden Ansprüche,
wobei die beiden Dichtungskörper (701a, 701b, 701d, 701e) jeweils ein Labyrinth von Dichtzonen (704a, 704b, 704c, 705a, 705b, 705c, 705d) umfassen.

11. Anordnung nach einem der vorstehenden Ansprüche,
wobei die beiden Dichtungskörper (101a, 101b) jeweils einen kreisförmigen Querschnitt aufweisen und im eingepressten Zustand etwas deformiert sein können.

12. Anordnung nach einem der Ansprüche 1 bis 10,
wobei die beiden Dichtungskörper (701a, 701b, 701d, 701e) jeweils zwei kreisförmig-ähnliche Elemente (701d, 701a) umfassen, die in Form einer Acht ausgebildet sind.

13. Anordnung nach Anspruch 12,
wobei das zuerst in die entsprechende Nut (702a) der Bauteilhälften (702) eingreifende kreisförmig ähnliche Element (701d) einen kleineren Durchmesser aufweist als das danach in die Nut (702a) eingreifende kreisförmig ähnliche Element (701a).

14. Anordnung nach Anspruch 12 oder 13,
wobei die Dichtung (701) ausgebildet ist, bereits beim Eingreifen des zuerst in die Nut (702a) eingreifenden kreisförmig ähnlichen Elements (701d) eine Dichtwirkung zu erzielen.

## Claims

1. Arrangement with two component halves (102, 103) and a seal (101) for sealing the component halves (102, 103), comprising the following features:
two sealing bodies (101a, 101b) which are formed symmetrically to one another and which are connected to one another in a plane of symmetry (110),
wherein the first sealing body (101a) engages in an at least radially or also additionally axially sealing manner in a groove (102a, 604a) of the first component half (102); and
wherein the second sealing body (101b) engages in an at least radially or also additionally axially sealing manner in a groove (103a) of the second component half (103) in order to seal the two component halves (102, 103) against each other, wherein the seal is formed along a closed line contour predetermined by the course of the groove,
wherein the seal (701) is formed as a one-piece elastomer extrusion-molded part, which is inserted, with excess length, into one of the grooves (102a, 103a) whereby a closed sealing profile ring is formed at which a sealing compression is generated at the front-side abutting surfaces by the excess length.

2. Arrangement according to claim 1,
wherein the two sealing bodies (101a, 101b) are formed in a conical manner.

3. Arrangement according to claim 1 or 2,
wherein the two sealing bodies (101a, 101b) are configured to elastically adapt to the respective grooves (102a, 103a) in a centering manner when engaging in the respective grooves (102a, 103a) of the two component halves (102, 103).

4. Arrangement according to one of the preceding claims, comprising a crosspiece (201c), which is arranged along the plane of symmetry (210) and connects the two sealing bodies (201a, 201b) with one another and forms an additional axial sealing plane.

5. Arrangement according to claim 4,
wherein the seal (201) is formed to be symmetrical both axially and radially.

6. Arrangement according to one of the preceding claims,
wherein the seal (101, 201) is formed to be circular, oval, rectangular, triangular, square, polygonal or in any line contour.

7. Arrangement according to one of the preceding claims,
wherein the seal (300) comprises a plurality of screw openings (305) for screwing the seal (300) to at least one of the two component halves (602, 603).

8. Arrangement according to one of the preceding claims,
wherein the two sealing bodies (701a, 701b) each comprise at least one bead (705c, 705d) radially circumferenting the respective sealing body (701a, 701b).

9. Arrangement according to claim 8,
wherein the two sealing bodies (701a, 701b) each comprise two beads (705c, 705d) radially circumferenting the respective sealing body (701a, 701b), which are respectively separated by a constriction; and wherein each bead develops its own sealing effect.

10. Arrangement according to one of the preceding claims,
wherein the two sealing bodies (701a, 701b, 701d, 701e) each comprise a labyrinth of sealing zones (704a, 704b, 704c, 705a, 705b, 705c, 705d).

11. Arrangement according to one of the preceding claims,
wherein the two sealing bodies (101a, 101b) each have a circular cross-section and can be slightly deformed in a pressed state.

12. Arrangement according to one of claims 1 to 10,
wherein the two sealing bodies (701a, 701b, 701d, 701e) each comprise two circular-like elements (701d, 701a), which are formed in a shape of an eight.

13. Arrangement according to claim 12,
wherein the circular-like element (701d) engaging firstly into the respective groove (702a) of the component halves (702) has a smaller diameter than the circular-like element (701a) engaging subsequently in the groove (702a).

14. Arrangement according to claim 12 or 13,
wherein the seal (701) is configured to already achieve a sealing effect when the circular-like element (701d) engaging firstly in the groove (702a) engages in the groove (702a).

## Revendications

1. Agencement doté de deux moitiés de composant (102, 103) ainsi que d'un joint d'étanchéité (101) pour étanchéifier les moitiés de composant (102, 103), présentant les caractéristiques suivantes :
deux corps d'étanchéité (101a, 101b) configurés symétriquement l'un par rapport à l'autre et reliés l'un à l'autre dans un plan de symétrie (110),
le premier corps d'étanchéité (101a) s'engageant au moins radialement ou également en outre axialement de manière étanche dans une rainure (102a, 604a) de la première moitié de composant (102) ; et
le deuxième corps d'étanchéité (101b) s'engageant au moins radialement ou également en outre axialement de manière étanche dans une rainure (103a) de la deuxième moitié de composant (103), afin d'étanchéifier les deux moitiés de composant (102, 103) l'une par rapport à l'autre,
le joint d'étanchéité étant réalisé le long d'un contour linéaire fermé, prédéfini par le tracé de la rainure,
le joint d'étanchéité (701) étant réalisé sous forme de pièce moulée en élastomère extrudé d'un seul tenant, qui est insérée avec une surmesure longitudinale dans l'une des rainures (102a, 103a), ce qui permet de former un anneau profilé d'étanchéité fermé, dans lequel une compression étanche est produite sur les surfaces de contact frontales par la surmesure longitudinale.

2. Agencement selon la revendication 1, dans lequel les deux corps d'étanchéité (101a, 101b) sont de forme conique.

3. Agencement selon la revendication 1 ou 2, dans lequel les deux corps d'étanchéité (101a, 101b) sont configurés pour s'adapter respectivement aux rainures (102a, 103a) en se centrant élastiquement lors de l'engagement dans les rainures (102a, 103a) respectives des deux moitiés de composant (102, 103).

4. Agencement selon l'une quelconque des revendications précédentes, doté d'une entretoise (201c) qui est agencée le long du plan de symétrie (210) et qui relie les deux corps d'étanchéité (201a, 201b) entre eux et forme un plan d'étanchéité axial supplémentaire.

5. Agencement selon la revendication 4, dans lequel le joint d'étanchéité (201) est formé de manière symétrique à la fois axialement et radialement.

6. Agencement selon l'une quelconque des revendications précédentes, dans lequel le joint d'étanchéité (101, 201) est configuré sous forme circulaire, ovale, rectangulaire, triangulaire, carrée, polygonale ou selon un contour linéaire quelconque.

7. Agencement selon l'une quelconque des revendications précédentes, dans lequel le joint d'étanchéité (300) comprend une pluralité d'ouvertures de vissage (305) pour visser le joint d'étanchéité (300) à au moins l'une des deux moitiés de composant (602, 603) .

8. Agencement selon l'une quelconque des revendications précédentes, dans lequel les deux corps d'étanchéité (701a, 701b) comprennent chacun au moins un bourrelet (705c, 705d) s'étendant radialement autour du corps d'étanchéité (701a, 701b) respectif.

9. Agencement selon la revendication 8, dans lequel les deux corps d'étanchéité (701a, 701b) comprennent chacun deux bourrelets (705c, 705d) s'étendant radialement autour du corps d'étanchéité (701a, 701b) respectif, qui sont séparés l'un de l'autre par un resserrement ; et dans lequel chaque bourrelet exerce une action d'étanchéité propre.

10. Agencement selon l'une quelconque des revendications précédentes, dans lequel les deux corps d'étanchéité (701a, 701b, 701d, 701e) comprennent chacun un labyrinthe de zones d'étanchéité (704a, 704b, 704c, 705a, 705b, 705c, 705d).

11. Agencement selon l'une quelconque des revendications précédentes, dans lequel les deux corps d'étanchéité (101a, 101b) présentent chacun une section transversale circulaire et peuvent être légèrement déformés à l'état enfoncé.

12. Agencement selon l'une quelconque des revendications 1 à 10, dans lequel les deux corps d'étanchéité (701a, 701b, 701d, 701e) comprennent chacun deux éléments de forme analogue à circulaire (701d, 701a) qui sont configurés sous la forme d'un huit.

13. Agencement selon la revendication 12, dans lequel l'élément de forme analogue à circulaire (701d) qui s'engage en premier dans la rainure correspondante (702a) des moitiés de composant (702) a un diamètre plus petit que l'élément de forme analogue à circulaire (701d) qui s'engage ensuite dans la rainure (702a).

14. Agencement selon la revendication 12 ou 13, dans lequel le joint d'étanchéité (701) est configuré pour produire une action d'étanchéité dès l'engagement de l'élément de forme analogue à circulaire (701d) qui s'engage en premier dans la rainure (702a).
